# EUROPEAN PATENT SPECIFICATION

(11) **EP 2 892 119 B1**
(45) Date of publication and mention of the grant of the patent: **27.11.2019**
(21) Application number: 14382237.7
(22) Date of filing: 19.06.2014
(51) Int. Cl.: H02G 3/12

(54) **FLEXIBLE BOX-FASTENING HOOK**
FLEXIBLER HAKEN ZUR BEFESTIGUNG EINES ANSCHLUSSKASTEN
CROCHET FLEXIBLE DE FIXATION POUR UN COFFRET

(30) Priority: 03.01.2014 ES 201430007
(43) Date of publication of application: 08.07.2015
(73) Proprietor: Simon, S.A.U., 08013 Barcelona (ES)
(72) Inventor: Riqué RebullL, Adrià, 08917 SANTA COLOMA DE GRAMENET (ES); Fusté Pardo, Carlos, 08370 CALELLA (ES); Villalobos Cortés, Félix, 08907 L'HOSPITALET DE LLOBREGAT (ES)
(74) Representative: Balder IP Law, S.L.

(56) References cited:
- EP-A2- 0 268 022
- DE-A1- 19 747 243
- DE-U1- 29 520 460
- NL-A- 9 002 656

## Description

### OBJECT OF THE INVENTION

The invention, as stated in the heading of the present heading, relates to a flexible box-fastening hook and the element to be fastened which houses said hook, giving the hook several advantages and innovative characteristics inherent to its particular configuration, which will be described in more detail below and which are an outstanding novelty in the current state of the art.

### FIELD OF APPLICATION OF THE INVENTION

The field of application of the present invention is included within the sector of the industry dedicated to the manufacturing of mechanisms, devices and accessories of electrical and electronic material.

### BACKGROUND OF THE INVENTION

Currently, the elements to fasten, for example electrical or electronic devices or the supports thereof, which are installed inside a box, are fastened through two very different mechanisms. In the first method, the box, where they are going to be installed, has a series of housings for screws and, thereby, the element be fastened is fastened to the box.

In the second method, when the box where the element to be fastened is going to be installed does not have housings for screws or the element to be fastened does not have means to be fastened using screws, the fastening is performed using a series of rigid hooks.

These hooks consist of rigid elements which emerge laterally from the body of the element to be fastened and which are fastened to the walls of the box using pressure by the tightening of the screws as they cause the hooks to open in the direction of the internal walls of the box where it will be installed.

With this solution, although the hooks described achieve the fastening of the body of the element to be fastened to the box, it is not fully effective since, in the event of possible movements of the body of the element to be fastened within the box, for example, highly frequent when said element to be fastened consists of a power point, the fastening weakens and the pressure of the hooks loses its strength. Furthermore, with the described disposal of the hooks inclination, the movement and the strength of pull which causes the extraction, of for example, a plug pin, may cause the body of the element to be fastened to come out of its location inside the box.

Furthermore, another drawback is that the hook system described makes the use of tools necessary, both for its installation and its de-installation. Likewise, another drawback is that each hook is independently fixed with its corresponding screw, which causes difficulties to correctly balance the position of the element to be fastened, since the pressure exerted by the screws may be different.

Finally, the curved movement of the hooks from the inside towards the internal walls of the box where it is going to be installed may cause the trapping of any of the power or control cables of the elements to fasten for which they are intended, with the subsequent risks of malfunctioning or short-circuit of the element to be fastened.

From EP0268022A2 it is known a tool used to fasten electrical devices to wall cavities, which possesses at least one flexible arm. In operation, the flexible arm is deformed to allow the fastening of the device.

It would, therefore, be desirable to have improved and faster fastening means between the element to be fastened and the box wherein it is incorporated, this being the essential objective of the present invention through the development of a new type of fastening hook, the design and structural configuration whereof are specifically devised to improve the aforementioned drawbacks.

As reference to the current state of the art, it should be indicated that the existence is unknown, at least by the applicant, of any other fastening hook with technical and structural characteristics similar to those shown here, as claimed.

DE29520460U1 discloses box-fastening hooks according to the preamble of claim 1, suitable for fastening electrical devices to a box.

### EXPLANATION OF THE INVENTION

More specifically, what the invention proposes is a flexible box-fastening hook according to claim 1.

For this purpose, and more specifically, the hook of the invention is configured from, at least, a part with at least one flexible part which can absorb a flexible deformation and which, once placed in the element to be fastened to a box, the distance between the joining point of the hook to the element to be fastened, whether a device or support, and the internal wall of the box to be installed is less than the projection of the distance between the same joining point of the hook and the distal end of the hook. Said distal end will be responsible for exerting pressure against the internal wall of the box for the fastening of the element to be fastened in question, through the accumulated elastic energy due to bend of the hook in the installation process.

In this way, in the installation process, the hook to come into contact with the box bends until the point of entering the box, the time when the distal end of said hook starts to touch the internal wall of the box, with an oblique direction towards the internal wall of the box and towards the opposite direction of the installation. From here, the "element to be fastened - hook" assembly slides with the friction between the distal end of the hook and the internal wall of the box until the final installation position.

Once the installation has been completed, and due to the fact that the distal end of the hook touches on the internal wall and is directed towards the internal wall of the box and in direction opposite the direction of the installation, in an extraction process of the element to be fastened said distal end presses obliquely in direction to the internal wall of the box and extraction direction, hindering the extraction of the element to be fastened already installed.

Furthermore, if the box, where the element to be fastened is going to be installed, has, optionally, a series of grooves, the pressure of the distal end of the hook is much greater, since it fixes much better between the grooves, increasing the necessary extraction force of the element to be fastened already installed.

Likewise, preferably, in the distal end of the hook fastening means are positioned which improve the grip of the hook with the box walls, consisting, for example, of teeth, claws or even edges, so that on trying to perform the extraction of the element to be fastened, they act driving into the internal wall of the box, even further increasing the amount of force necessary for the extraction of the element to be fastened due to the oblique direction towards the internal wall of the box and in direction opposite the installation of the element to be fastened.

In an option of embodiment, the hook constitutes an independent part which has a joining section, which may consist of a straight section which is fixed by any appropriate means to the element to be fastened.

Finally, it should be mentioned that the hook has a manual gripping surface to unfasten it from the internal walls of the box, or where applicable, to unfasten the fastening means said hook has, whether claws, teeth or edges, and easily extract the element to be fastened already installed, optionally existing on said surface an orifice which allows insertion of a tool to perform said operation if so desired, since in certain solutions the space existing or said grip may be very tight.

The described flexible fastening hook in a box, since, is an innovative structure of characteristics unknown until know for the intended purpose, reasons which, together with its practical usefulness, give it sufficient grounds to obtain the privilege of exclusiveness applied for.

### DESCRIPTION OF THE DRAWINGS

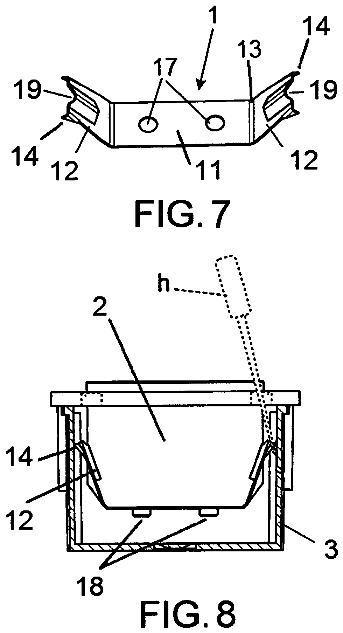

To complement the description being made and in order to aid towards a better understanding of the characteristics of the invention, a set of drawings is attached as an integral part of said description wherein, with illustrative and non-limiting character, the following has been represented:

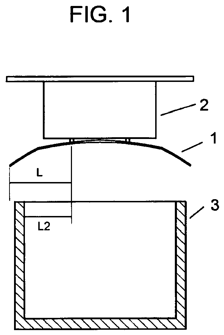

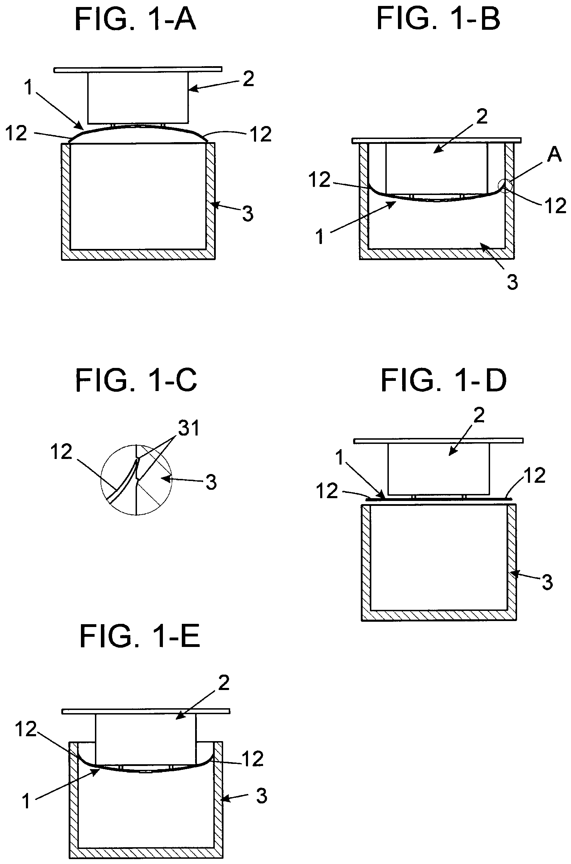

- Figure 1.-: Shows a simplified diagram of two flexible box-fastening hooks and the element to be fastened that said hooks have, all represented in exploded view.
- Figure number 1-A.-: Shows a diagrammatic sectional view of a simplified example of two flexible box-fastening hooks and the element to be fastened, in this case a device, which houses said hooks, object of the invention, grouped the hooks with concave form and in a phase before its installation, all as a reflection of figure 1 above;
- Figure number 1-B.-: Shows a diagrammatic view the same as that of figure 1-A but with the element already installed, where due to the contact of the flexible hooks with the box, the distal ends of the hooks now have a direction in the internal walls of the box and a direction opposite that of the installation;
- Figure number 1-C.-: Shows an expanded view of detail A indicated in figure 1-B, and which shows the disposal of the distal end of the hook on the internal wall of the box in direction to the internal wall and in direction opposite the direction of the installation of the element or device;
- Figure number 1-D.-: Shows a diagrammatic view in section of a simplified example of two flexible box-fastening hooks and the element to be fastened, in this case another device grouped the hooks horizontally and in a phase before that of their installation.
- Figure number 1-E.-: Shows a diagrammatic view equivalent to that of figure 1-D but with the device already installed, where due to the contact of the flexible hooks with the box, the distal ends of the hooks now have a direction in the internal walls of the box and a direction opposite that of the installation.
- Figures number 2-A and 2-B.: Show different perspective views of flexible hooks not covered by the present invention;
- Figures number 3 and 4.-: Show two similar examples of flexible fastening hooks in this case forming a part with three hooks grouped by a same joining section and as element independent of the element to be fastened it is intended for;
- Figure number 5.-: Shows a perspective view of an example of box and of the element to be fastened, in this case the base of a device, with three hooks not covered by the present invention;
- Figure number 6.-: Shows a perspective view of an example of box and of an element to be fastened, in this case of a support of a device wherein three hooks not covered by the invention are incorporated forming an integral part of said support;
- Figure number 7.-: Shows a perspective view and a variant of two dos hooks according to the present invention; and
- Figure number 8.-: Shows a sectional view of a box, the hook of figure 7 and the element to be fastened, in this case of a device, fastened to the hooks and showing the extraction system thereof.

### PREFERRED EMBODIMENT OF THE INVENTION

In light of said figures, and in accordance with the numbering adopted, several examples of non-limiting embodiment can be observed therein of a flexible box-fastening hook and different elements to fasten, such as, for example, supports and electrical and electronic devices, which house said hook where the hook comprises the parts and elements indicated and described in detail below.

As observed in figures 1, 1-A to 1-E, the hook (1) in question, applicable to obtain the fastening of an element to be fastened (2), in this case a device, to be installed in a box (3), in this example, of the type embedded in a wall, is configured from, at least, a part with, at least, a flexible part and with at least one distal end (12) and which, once the hook is placed in the element to be fastened (2), a first horizontal projection (L) between the joining point of the hook (1) with the element to be fastened (2) and the distal end (12) of the hook (1) is greater than a second horizontal projection (L2) between the same joining point of the hook (1) and the internal wall of the box (3).

The distal end (12) is that in charge of exerting pressure on the internal wall of the box (3) for the fastening of the element to be fastened (2) in question, said pressure originating from the elastic energy accumulated by the bending of the hook (1) during the installation. In this way, in the installation process, the hook (1) on coming into contact with the box (3) bends until being able to enter inside the box (3), the time when the distal end (12) of the hook (1) touches the internal wall of the box (3), with a m oblique direction towards the internal wall of the box (3) and towards the opposite direction of the installation. From here, the element to be fastened (2) - hook (1) assembly slides with the friction between the distal end (12) of the hook (1) and the internal wall of the box (3) until the final installation position.

Furthermore, the box (3) has, optionally, a series of grooves (31) in the internal wall thereof in coincidence with the position of said distal end (12) of the hook (1), said grooves (31) helping to fasten much better the distal end (12) in the inner walls of the box (3) increasing, therefore, the necessary extraction force of the element to be fastened (2) installed there.

Likewise, preferably, in the distal end (12) of the hook (1) is contemplated the existence of fastening means (14) which improve the grip thereof with the internal walls of the box (3) consisting, for example, of teeth, claws or edges, which, on attempting to perform the extraction of the element to be fastened (2), act by way of a fish hook, driving even further into the internal wall of the box (3), increasing the amount of force necessary to extract the element to be fastened (2).

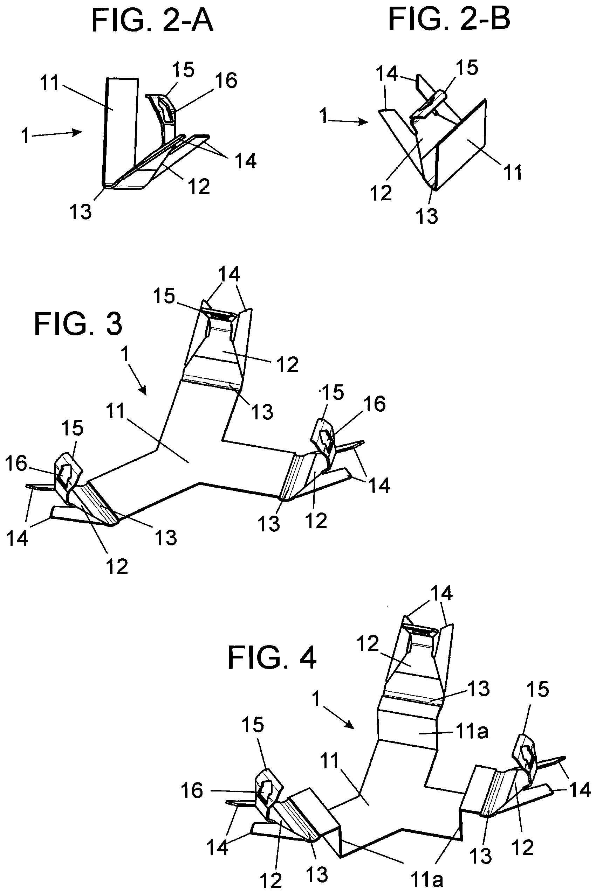

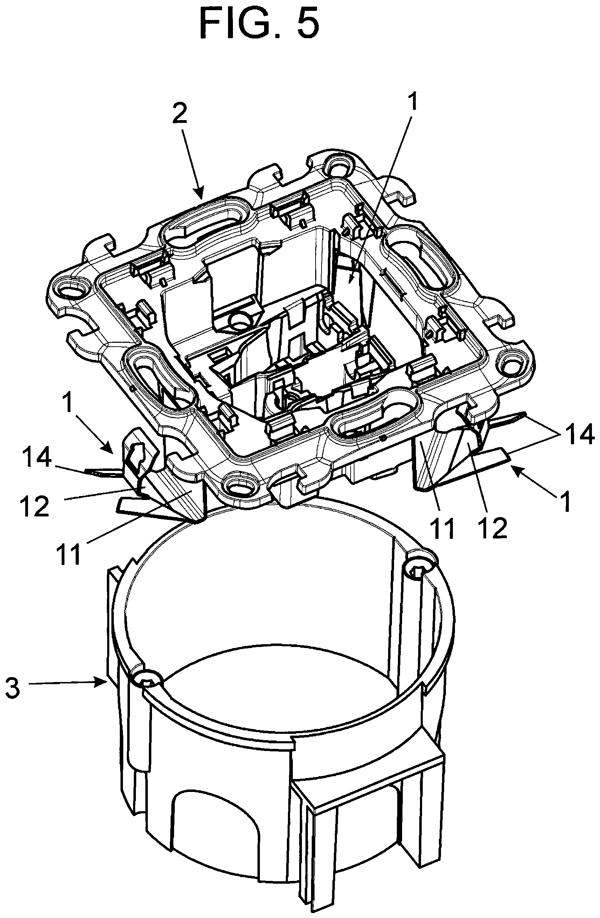

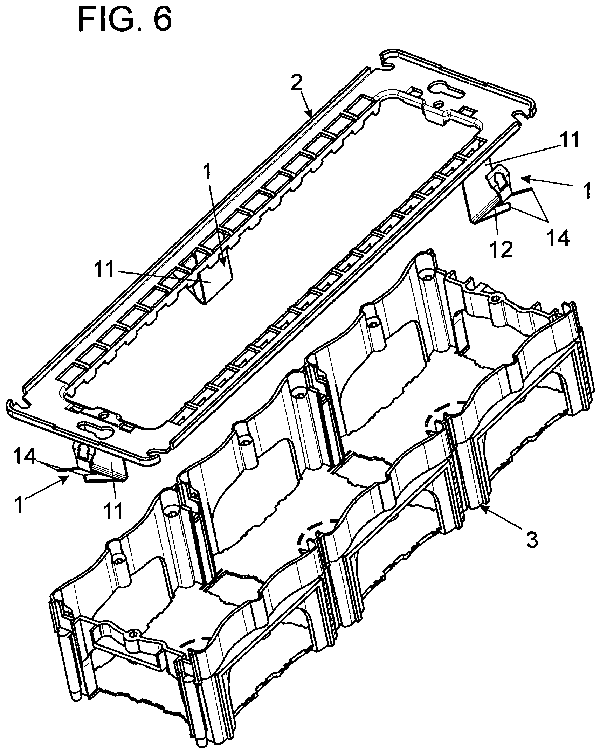

In an option of embodiment, such as that shown in figures 3 and 4, the hook (1) is independent of the element to be fastened (2) and consists of a part bent in several sections comprising, at least, a joining section (11) and, at least, two flexible distal ends (12) joined to said joining section (11) by an elastic bridge (13), determined by a transversal groove, the joining section (11) being designed to be joined to the element to be fastened (2) the distal end (12), including different claws as fastening means (14), being oriented in the direction opposite the direction of the installation of the element to be fastened (2) inside the box (3).

In said figures, the hook (1) is an element independent of the element to be fastened (2) and it contemplates several flexible distal ends (12) joined together by a single joining section (11) designed to be joined to the element to be fastened (2).

Optionally, as shown in figure 4, said joining section (11) has a step (11a) for a better adaptation to the element to be fastened (2).

Preferably, furthermore, the flexible distal end (12) of the hook (1) has a gripping surface (15) with an edge curved towards said distal end (12), to unfasten the hook (1) and easily extract the element to be fastened (2) from the inside of the box (3), there optionally being on said surface an orifice (16) suitable for the insertion of a tool (h) to perform said extraction operation.

Furthermore, preferably, when the element to be fastened (2) is a device, it may have an opening at the height of the gripping surface (15) of the hook, so that said gripping surface (15) can be introduced by it and facilitate the extraction of the hook (1) through the lid which covers the device.

In an option of more simplified embodiment (figures 7 and 8) the hook (1) of two distal ends (12) has as fastening means to an element to be fastened (2) orifices (17) where the same number of lugs (18) which appear in the lower part of the element to be fastened (2) shall be inserted in correspondence (2).

Furthermore, as an alternative system for the extraction of the hook (1), it has a recess (19) at each distal end (12) to help the introduction of a tool (h) and facilitate the extraction of hook (1).

Having sufficiently described the nature of the present invention, as well as the manner of putting it into practice, it is not considered necessary to give further explanation in order for any person skilled in the art to understand its scope and the advantages derived therefrom, stating that, within is essential nature, it can be put into practice in other forms of embodiment that differ in details from those indicated by way of example, and whereto protection claimed will equally cover, provided that its main principle is not altered, changed or modified.

## Claims

1. Flexible box-fastening hook, for fastening electrical devices and/or for the support of said devices, applicable to obtain the fastening of said devices(2) to a box (3) which comprises, at least, one part with, at least one flexible part and with two distal ends (12) and which, once placed in the element to be fastened (2), a first horizontal projection (L) between the joining point of the hook (1) with the element to be fastened (2) and any of the distal ends (12) of the hook (1) in an uninstalled condition is greater than a second horizontal projection (L2) between the same joining point of the hook (1) with the element to be fastened (2) and the same distal end (12) of the hook (1) in an installed condition in a box (3) **characterized in that** the part constituting the hook (1) is independent of the element to be fastened (2) and the flexible box-fastening hook comprises a part bent in several sections comprising a joining section (11) designed to be joined to the element to be fastened (2) and two distal ends (12) joined to the joining section (11), the two distal ends (12) being diametrically opposed with respect to the joining section (11), wherein the distal end (12) has a recess (19) suitable for the insertion of a tool (h) to perform the extraction operation, wherein the distal end (12) of each hook (1) has fastening means (14) for the improvement of the grip between the hook (1) and the internal walls of the box (3), wherein the distal end (12) has a gripping surface (15) to unfasten the hook (1) and easily extract the element to be fastened (2) from the inside of the box (3), wherein as fastening means between the element to be fastened (2) and the hook (1), the joining section (11) of the hook (1) has at least one orifice (17).

2. Flexible box-fastening hook for fastening electrical devices and/or for the supports of said devices to a box (3) according to claim 1, **wherein** the fastening means (14) in the distal end (12) of the hook (1) are formed by at least one gripping claw.

3. System for fastening electrical devices and/or for the support of said devices to a box (3), the system comprising an electrical device and the flexible box-fastening hook of claims 1 or 2, **wherein** the electrical devices and/or the supports of said devices has at least one opening at the height of the gripping surface (15) of the hook, on top of the recess (19) so that a tool (h) may reach the recess (19) or orifice (16), and wherein the electrical devices and/or the supports of said devices and a box (3) has at least one lug (18) for its introduction in the corresponding orifice (17) of the joining section (11) of the hook (1).

## Patentansprüche

1. Flexibler Gehäusebefestigungshaken zum Befestigen von elektrischen Einrichtungen und/oder für die Halterung dieser Einrichtungen, anwendbar zum Befestigen der Einrichtungen (2) an einem Gehäuse (3), der mindestens ein Teil mit mindestens einem flexiblen Teil und mit zwei distalen Enden (12) umfasst und von dem, wenn er in dem zu befestigenden Element (2) platziert ist, ein erster horizontaler Vorsprung (L) zwischen der Verbindungsstelle des Hakens (1) mit dem zu befestigenden Element (2) und einem der distalen Enden (12) des Hakens (1) in einem nicht installierten Zustand größer ist als ein zweiter horizontaler Vorsprung (L2) zwischen der gleichen Verbindungsstelle des Hakens (1) mit dem zu befestigenden Element (2)) und dem gleichen distalen Ende (12) des Hakens (1) in einem installierten Zustand in einem Gehäuse (3), **dadurch gekennzeichnet, dass** der Teil, der den Haken (1) bildet, unabhängig von dem zu befestigenden Element (2) ist und der flexible Gehäusebefestigungshaken ein in mehreren Abschnitten gebogenes Teil, das einen Verbindungsabschnitt (11) umfasst, der ausgebildet ist, um mit dem zu befestigenden Element (2) verbunden zu werden, und zwei distale Enden (2), die mit dem Verbindungsabschnitt (11) verbunden sind, umfasst, wobei die beiden distalen Enden (12) bezogen auf den Verbindungsabschnitt (11) diametral entgegengesetzt sind, wobei das distale Ende (12) eine Aussparung (19) aufweist, die zum Einführen eines Werkzeugs (h) zum Ausführen eines Entnahmevorgangs geeignet ist, wobei das distale Ende (12) jedes Hakens (1) Befestigungsmittel (14) zur Verbesserung der Griffigkeit zwischen dem Haken (1) und den Innenwänden des Gehäuses (3) aufweist, wobei das distale Ende (12) eine Greiffläche (15) aufweist, um den Haken (1) zu lösen und das zu befestigende Element (2) leicht aus dem Inneren des Gehäuses (3) zu entnehmen, wobei der Verbindungsabschnitt (11) des Hakens (1) als Befestigungsmittel zwischen dem zu befestigenden Element (2) und dem Haken (1) mindestens eine Öffnung (17) aufweist.

2. Flexibler Gehäusebefestigungshaken zum Befestigen von elektrischen Einrichtungen und/oder für die Halterung dieser Einrichtungen an einem Gehäuse (3) nach Anspruch 1, **wobei** die Befestigungsmittel (14) in dem distalen Ende (12) des Hakens (1) durch mindestens eine Greifklaue gebildet sind.

3. System zum Befestigen von elektrischen Einrichtungen und/oder für die Halterung dieser Einrichtungen an einem Gehäuse (3), wobei das System eine elektrische Einrichtung und den flexiblen Gehäusebefestigungshaken nach Ansprüchen 1 oder 2 umfasst, **wobei** die elektrischen Einrichtungen und/oder die Halterungen dieser Einrichtungen über der Ausnehmung (19) mindestens eine Öffnung in der Höhe der Greiffläche (15) des Hakens aufweisen, so dass ein Werkzeug (h) die Ausnehmung (19) oder Öffnung (16) erreichen kann, und wobei die elektrischen Einrichtungen und/oder die Halterungen dieser Einrichtungen und ein Gehäuse (3) mindestens eine Nase (18) zum Einführen in die entsprechende Öffnung (17) des Verbindungsabschnitts (11) des Hakens (1) aufweisen.

## Revendications

1. Crochet flexible de fixation pour un coffret, pour fixer des dispositifs électriques et/ou pour le support desdits dispositifs, applicable pour obtenir la fixation desdits dispositifs (2) sur un coffret (3) qui comprend, au moins, une partie avec au moins une partie flexible et avec deux extrémités distales (12) et qui, une fois placée dans l'élément à fixer (2), une première saillie horizontale (L) entre le point d'assemblage du crochet (1) avec l'élément à fixer (2) et l'une quelconque des extrémités distales (12) du crochet (1) dans une condition non installée est supérieure à une seconde saillie horizontale (L2) entre le même point d'assemblage du crochet (1) avec l'élément à fixer (2) et la même extrémité distale (12) du crochet (1) dans une condition installée dans un coffret (3), **caractérisé en ce que** la partie constituant le crochet (1) est indépendante de l'élément à fixer (2) et le crochet flexible de fixation pour un coffret comprend une partie pliée en plusieurs sections comprenant une section d'assemblage (11) conçue pour être assemblée à l'élément à fixer (2) et deux extrémités distales (12) assemblées à la section d'assemblage (11), les deux extrémités distales (12) étant diamétralement opposées par rapport à la section d'assemblage (11), dans lequel l'extrémité distale (12) a un évidement (19) approprié pour l'insertion d'un outil (h) pour réaliser l'opération d'extraction, dans lequel l'extrémité distale (12) de chaque crochet (1) a des moyens de fixation (14) pour l'amélioration de la préhension entre le crochet (1) et les parois internes du coffret (3), dans lequel l'extrémité distale (12) a une surface de préhension (15) pour détacher le coffret (1) et extraire facilement l'élément à fixer (2) de l'intérieur du coffret (3), dans lequel en tant que moyens de fixation entre l'élément à fixer (2) et le crochet (1), la section d'assemblage (11) du crochet (1) a au moins un orifice (17).

2. Crochet flexible de fixation pour un coffret pour fixer des dispositifs électriques et/ou pour les supports desdits dispositifs sur un coffret (3) selon la revendication 1, dans lequel les moyens de fixation (14) dans l'extrémité distale (12) du crochet (1) sont formés par au moins un crochet de préhension.

3. Système pour la fixation de dispositifs électriques et/ou pour le support desdits dispositifs sur un coffret (3), le système comprenant un dispositif électrique et le crochet flexible de fixation pour un coffret selon les revendications 1 ou 2, dans lequel les dispositifs électriques et/ou les supports desdits dispositifs ont au moins une ouverture à la hauteur de la surface de préhension (15) du crochet, sur la partie supérieure de l'évidement (19) de sorte qu'un outil (h) peut atteindre l'évidement (19) ou l'orifice (16), et dans lequel les dispositifs électriques et/ou les supports desdits dispositifs et un coffret (3) ont au moins une patte (18) pour leur introduction dans l'orifice (17) correspondant de la section d'assemblage (11) du crochet (1).
